# EUROPEAN PATENT APPLICATION

(11) **EP 2 159 846 A1**
(43) Date of publication of application: **03.03.2010**
(21) Application number: 08015293.7
(22) Date of filing: 29.08.2008
(51) Int. Cl.: H01L 31/0224, H01L 31/05

(54) **Thin film solar cell and photovoltaic string assembly**

(71) Applicant: ODERSUN Aktiengesellschaft, 15236 Frankfurt (Oder) (DE)
(72) Inventor: Tober, Olaf, 10437 Berlin (DE); Winkler, Dr. Michael, 12589 Berlin (DE); Koschack, Dr. Thomas, 15295 Wiesenau (DE); Penndorf, Dr. Jürgen, 15236 Frankfurt (Oder) (DE); Levermann, bastian, 15518 Langewahl (DE); Brauer, Wolfgang, 15232 Frankfurt (Oder) (DE); Lang, Gerd, 15236 Frankfurt (Oder) (DE)
(74) Representative: Kinkeldey, Daniela

(57) **Abstract**

The present invention relates to a thin film solar cell, in particular in strip-like form, a photovoltaic string assembly comprising at least two solar cells according to the invention, a method of manufacturing a solar cell according to the invention, a method of electrically connecting at least two solar cells according to the invention and a method of producing a photovoltaic string assembly comprising the solar cells of the invention.

## Description

### FIELD OF THE INVENTION

The present invention relates to a thin film solar cell, also called photovoltaic element, in particular in strip-like form, a photovoltaic string assembly comprising at least two solar cells according to the invention, a method of manufacturing a solar cell according to the invention, a method of electrically connecting at least two solar cells according to the invention and a method of producing a string assembly comprising the solar cells of the invention.

### DESCRIPTION OF THE RELATED ART

Currently crystalline silicon technologies are the most common ones hence the market for photovoltaic solar cells and panels is still dominated by crystalline silicon products. In these technologies solar cells with a thickness of approx. 0.3 mm were manufactured on small areas of 0.03 m². The electrical joining of these cells in a separate process results in the creation of large surfaces. Unfortunately these products are expensive because of the high consumption of silicon and the complex manufacturing processes. New technologies, especially low-cost thin film technologies, are expected to gain an increasing share of the market in the coming years. These concepts use a different procedure to produce solar modules at far lower costs. In these procedures, in general, solar cells of only few µm in thickness are deposited directly onto large surfaces, mainly glass, and then parts of them are connected in series by inline cutting processes. A uniform deposition of the individual metal and semiconductor layers over the whole surface is a decisive prerequisite for homogeneous photoelectric properties. The current developments show that long periods of times are needed to adapt the processes developed in the laboratory on module areas of approx. 10 cm² to larger ones. Larger surfaces need new parameter sets and the number of inhomogeneities increases which causes a lower efficiency. The size of the vacuum coating installation defines the size of the solar panels, and any increase in size requires new production installations and new optimization of all process parameters.

The thin film CISCuT technology, also called CIS (copper indium selenium/sulphur) on Cu Tape, now offers the possibility to produce solar modules at a far lower cost than those from crystalline silicon and to overcome the specific difficulties of the common thin film concepts such as large-area homogeneity and long terms and high investments for scaling up. CISCuT is a reel-to-reel technology, working in a series of mainly non vacuum processes, treated on metal foils of 1 cm in width, yielding a quasi endless solar cell tape. Mechanically flexible, uniform anthracite-like colored solar laminates will be produced by interconnecting the overlapped tape stripes and by embedding same into functional foils. In this thin film concept, the equipment for the solar cell production is fully independent on shape and size of the solar modules. Changes in module sizes do not need any changes or up-scaling of the production equipment.

Thin film solar cells comprising a carrier, a back electrode, an absorber layer, possibly a buffer layer, and a front electrode and having a potential barrier are known. These solar cells all require a p-n or a p-i-n junction which is based on the materials used in order to obtain the solar cell.

A set up for the fabrication of quasi endless solar cells in consecutive reel-to-reel processes and assembling afterwards modules from these cells is e.g. described in güldner, R., Penndorf, J., Winkler, M., Tober, O., 2000 Flexible, Polymer Encapsulated Solar Modules - A New Concept for Cu-In-S Solar Devices Produced by the CISCuT Technology Proc. 16th EPSEC, Glasgow, UK, pp. 2289 - 2292. The basic steps of the production of solar cells is e.g. described in M. Winkler, J., Griesche, J., Konovalov, I.; Penndorf J., Wienke, J., Tober, O., "CISCuT - solar cells and modules on the basis of CuInS2 on Cu-tape", Solar Energy 77, 2004, pp. 705 -716 and M. Winkler, J., Griesche, J., Konovalov, I.; Penndorf J., Tober, O., "Design, Actual Performance, and Electrical Stability of CISCuT-Based Quasi-Endless Solar Cell Tapes", Mat. Res. Soc. Symp. Proc 2001, pp. 668.

DE 196 34 580 describes thin film solar cells which are based on the CIS (copper, indium, selenium/sulphur) technology. In DE 196 34 580 the solar cells are produced by providing a carrier made of copper which is coated with indium, gallium or mixtures thereof. Subsequently, the coated carrier is contacted with selenium and/or sulphur in order to build the absorber layer. The thus obtained absorber layer may be of the CIS type. These CIS type absorber layers are n-conductive and therefore require a certain front electrode in order to ensure the presence of the n-p junction in the solar cell. On top of the absorber layer, a front electrode made of a p-conductive transparent material, such as copper (I) oxide, is applied.

EP 1 052 702 discloses thin film solar cells based on Ib/IIIa/VIa compounds and a process for their preparation. The absorber layer in these cells is a polycrystalline layer made from a heterogeneous mixture of two Ib/IIIa/VIa compounds which are stapled over each other, i.e. the absorber layer comprises two distinct absorber layers. The absorber layer in this assembly additionally shows a potential barrier in its volume and has a p-conductive material on the surface.

EP 1 052 703 discloses thin film solar cells based on Ib/IIIa/VIa compounds and a process for their preparation. The back electrode in these solar cells is made of intermetallic phases of the same Ib and IIIa metals which are used in order to produce the absorber layer.

It is also known to assemble these solar cells to photovoltaic modules which are then used to produce electric energy. DE 100 20 784 discloses one possible way to assemble these solar cells into modules, wherein several groups of solar cell connected in series, are arranged in such a way that these groups are connected in parallel. In order to achieve this, the back electrode of a first solar cell of each group is electrically connected with the back electrode of the last solar cell of each group of solar cells.

Such solar cells and the modules assembled therewith have the disadvantage that due to the production process the lateral edges or sides thereof will have an undefined structure which might lead to problems with regard to the efficacy of the solar cells, in particular when assembling same into modules. In thin film solar cells the absorber layer is only some microns in thickness, and therefore the front and back electrode also only have a distance in the thickness of the absorber layer. If the thin film solar cells are first produced as a quasi endless strip or band and then cut into separate solar cells, another problem is that additionally at the locations of cutting again undefined structures may be produced. These undefined structures may be a smearing of the front electrode and/or the back electrode over the side of the solar cell which can result in a direct connection of the front and the back electrode. If the front electrode and the back electrode are, however, directly connected, a short circuit is the consequence leading to a loss of efficiency of the solar cell.

One suggestion to overcome these problems is described in WO 00/62347 in that a solar cell is provided with an absorbing layer which is arranged on a flexible and band-shaped support. The absorbing layer is at least partially provided with components of copper and is provided with at least one element from the group of indium and gallium and with at least one element from the group of selenium and sulphur and is at least partially embodied as p-type. The absorbing layer is at least partially deposited on the support in a plating manner. An isolating layer can be coated on the support so that defined, uncoated areas, onto which the absorbing layer will be applied, are obtained. The areas onto which the absorbing layer is applied will eventually form the solar cells. After the production process, the band is cut into discrete solar cells at the locations where the isolator was coated onto the support. However the edges between coated and uncoated areas may still have undefined structures, in particular a direct contact between the front and back electrode.

Additionally, due to the cutting process according to WO 00/62347, again undefined structures are introduced at the edges or sides of the solar cells and the isolator cannot serve as an electrical barrier between the layers.

Due to production variations undefined structures may furthermore be present at locations different from the edges or sides of the solar cells which may also cause problems with regard to the efficacy of the solar cells. Such undefined structures may lead to problems with regard to the efficacy of the solar cells as they may cause short circuits or similar defects within each solar cell or between solar cells when assembled into modules. In particular, such undefined structures may be due to manufacturing imprecision in that the layers are not equally applied over the whole area. Therefore, the front electrode may come into direct contact with the back electrode and/or the carrier at other locations on the solar cell than the edges or sides thereof and, thus causing a short circuit at these locations. Such locations are also call "shunts".

If the production of the solar cell is conducted starting with a carrier and then applying the various layers upon each other and at the end the front electrode, the front electrode might, due to production variation, not only be applied on top of the last layer but also on the edges or sides thereof. Therefore, the front electrode might come into direct contact with the back electrode and/or the carrier. Therewith the efficacy of the solar cell is impaired as the locations at which the front electrode is in contact with the back electrode and/or the carrier will cause short circuits.

Additionally if a long strip-like solar cell is cut into discrete solar cells of a desired length, also at the cutting edges the front electrode might come into direct contact over the cutting edge because the front electrode might "smear" over the edge during cutting due to its low hardness.

Therefore the problem underlying the invention is to provide a solar cell which overcomes the above problems, in particular in which undefined structures are not present and/or its effect(s) are abolished and which have a high efficacy.

Another problem underlying the invention is to provide a string assembly of solar cells according to the invention which overcomes the above problems when electrically connecting the solar cell, in particular which has a high output of electrical energy. The solar cells according to the invention have a high efficacy because the occurrence of short circuits over the edges or within the solar cells is substantially avoided.

Another problem underlying the invention is to provide an economical and dependable process for the production of solar cells and the string assemblies made there from.

The solutions of these problems are thin film solar cells, photovoltaic string assemblies comprising same, a method of manufacture of the solar cells and the string assemblies according to the claims.

### SUMMARY OF THE INVENTION

In a brief description the invention relates to a thin film solar cell (10) comprising an electrically conductive carrier (1), a back electrode (2) which is directly on top of said carrier, an absorber layer (3) and a front electrode (4) wherein

the front electrode (4) is divided into at least two parts (7, 8) wherein at least one part (8) of the front electrode of the solar cell is isolated from the electrically conductive carrier and the back electrode and at least one second part (7) of the front electrode that is electrically not isolated from the electrically conductive carrier and the back electrode of said solar cell, and preferably additionally comprising at least one electrically isolating structure (6) preventing direct electrical contact of the electrically conductive carrier (1) and the back electrode (2) of said first solar cell, usually via the front electrode (4), in particular via at least one second part (7), with an electrically conductive carrier (1') and/or a back electrode (2') of a second solar cell (10') when brought into contact with the front electrode (4) of said solar cell (10).

In general, the incidence of light in order to produce electrical energy in the solar cells of the invention is from the side of the front electrode on top of the solar cell, in particular via the at least one part (8). Thus, the general structure of the solar cells according to the invention, starting from the side of the incidence of light on the solar cell, comprises in the following sequence a front electrode which is transparent in order to allow light to shine through and to collect and to conduct the electrical energy produced, an absorber layer forming the photoactive diode which serves the purpose to absorb the light and transform it to electrical energy, a back electrode which is the counter electrode for the front electrode and an electrically conductive carrier which is the mechanical carrier of all layers and will also serve the purpose to conduct the electrical energy collected from one solar cell to another if connected.

The division of the front electrode in the solar cells of the invention will have the effect that the solar cells will comprise part (8) of the front electrode which is isolated and at least one part (7), preferably at least two parts (7) and (7') of the front electrode which are not isolated from the back electrode and the electrically conductive carrier. Thus, the active solar cells of the invention will not have undefined structures on the edges thereof, i.e. the effects of such undefined structures are abolished. Consequently, no short circuits between different layers of the solar cell in use will occur. In particular the division of the front electrode will prevent an electrical connection of that part (8) of the front electrode that serves to collect and to conduct the electrical energy produced during use and the back electrode and/or the conductive carrier. Therewith short circuits within one solar cell by the direct connection of front electrode and back electrode and/or electrically conductive carrier are prevented.

Preferably, the solar cells of the invention additionally comprise at least one isolating structure (6). This at least one isolating structure (6) in the solar cells of the invention will have the effect that an electrical connection between the back electrode and/or the conductive carrier of a first solar cell (10) and the back electrode and/or the conductive carrier of a second solar cell (10') which is brought into contact with the first solar cell is prevented. Such an electrical contact without an isolating structure (6) might occur due to the presence of undefined structures at the edges of the solar cell, in particular parts of the front electrode which extend over the edges of the solar cell due to the production process.

The provision of the division of the front electrode resulting in a part (8) of the front electrode which is electrically isolated from the back electrode and the electrically conductive carrier and optionally an additional isolating structure (6) in the solar cell will have the advantage that on the one hand undesirable electrical connections between layers within one solar cell and on the other hand between two solar cells brought into electrical contact with each other are avoided.

Additionally the invention relates to a photovoltaic string assembly (15) comprising at least two solar cells (10, 10') according to the invention electrically connected in series, wherein the front electrode of a first solar cell is connected to the electrically conductive carrier and/or the back electrode of a second solar cell.

Furthermore the invention relates to a method of manufacturing a solar cell according to the invention comprising the steps of
a) providing a solar cell (10) comprising an electrically conductive carrier (1), a back electrode (2), an absorber layer (3), optionally an buffer layer on top of the absorber layer and a front electrode (4);
b) dividing the front electrode (4) into at least two parts (7, 8) for electrically isolating at least one part (8) of the front electrode (4) of the solar cell from the electrically conductive carrier (1) and the back electrode (2) and providing at least one second part (7) of the front electrode (4) that is electrically not isolated from the electrically conductive carrier (1) and the back electrode (2) of said solar cell, or dividing the front electrode (4) preferably into at least five parts (7, 7', 8, 16, 16') for electrically isolating at least one part (8) of the front electrode (4) and providing at least four parts (7, 7', 16, 16') of the front electrode (4) that are electrically not isolated from the electrically conductive carrier (1) and the back electrode (2) of said solar cell and
c) optionally providing an at least one electrically isolating structure (6) in order to prevent direct electrical contact of the electrically conductive carrier (1) and the back electrode (2) of said solar cell and an electrically conductive carrier (1') and the back electrode (2') of a second solar cell (10') brought into contact with the front electrode (4) of said solar cell (10).

Additionally the invention relates to a method of electrically connecting at least two solar cells of the invention comprising the steps of providing a first solar cell (10) according to the invention, providing a second solar cell (10') according to the invention, and electrically connecting the front electrode of the first solar cell with the back electrode of the second solar cell via the electrically conductive carrier to build a photovoltaic string assembly.

Additionally the invention relates to a method of electrically connecting at least two solar cells of the invention by comprising the steps of providing a first solar cell according to the invention, providing a second solar cell according to the invention, and electrically connecting the front electrode, in particular part (8) thereof which is electrically isolated as described above, of the first solar cell with the back electrode of the second solar cell via overlapping of second solar cell to first solar cell, i.e. in an imbricate manner.

Finally, the invention relates to a method of producing a photovoltaic string assembly comprising at least two solar cells according of the invention comprising
i) providing a first solar cell (10) by conducting a process comprising the steps of
   i1) providing an electrically conductive carrier (1);
   i2) optionally cleaning the electrically conductive carrier (1);
   i3) applying a back electrode (2) on the conductive carrier (1);
   i4) applying an absorber layer (3) on the back electrode (2) and optionally removing material not being part of the absorber layer on the surface and optionally annealing the absorber layer (3);
   i5) optionally applying a buffer layer on the absorber layer (3) and optionally cleaning the surface of the buffer layer; and
   i6) applying a front electrode (4) on the absorber layer or, if present, the buffer layer and
   i7) optionally cleaning the electrically conductive carrier (1);
j) dividing the front electrode (4) into at least two parts (7, 8) by removing parts of the front electrode (4) along at least one edge thereof;
   in particular optionally dividing the front electrode (4) into at least five parts (7, 7', 8, 16, 16') provided by grooves (5, 5' and 5" and 5"') preferably by partially removing the front electrode, preferably the front electrode and the buffer layer, if present, via laser
k) optionally passivating at least one shunt (12) by removing parts of the front electrode at the area of the shunt (12), therewith creating at least one part of the front electrode (13) which is located around the shunt and isolated from the rest of the front electrode (4);
l) optionally removing at least part of part (7) of the front electrode (4) in order to eliminate an electrical contact between part (7) of the front electrode and the back electrode and/or the electrically conductive carrier;
m) optionally removing particles and superficial parts of the buffer layer from the surfaces of the solar cell;
n) applying at least one isolating structure (6) by applying at least one electrical isolator on top of the front electrode (4) on to at least part (7) which is electrically not isolated from the electrically conductive carrier (1) and the back electrode (2);
o) optionally applying at least one additional isolating structure (6') by applying at least one electrical isolator on top of the back electrode (2) and/or the electrically conductive carrier (1);
p) optionally applying at least one additional structure (14) by applying at least one electrical isolator at least on top of the part (13) of the front electrode (4);
q) optionally applying at least one additional structure (14') by applying at least one electrical isolator at least on top of the part (16) of the front electrode (4);
r) providing at least one electrically non-conductive sheet of high optical transmission and mounting a first solar cell (10) with its front electrode thereon;
s) applying a conductive adhesive (9) on part of the back electrode (2) and/or electrically conductive carrier (1) which will be brought into electrical contact with that part (8') of the front electrode of a second solar cell (10') which is electrically isolated from the electrically conductive carrier (1') and the back electrode (2') of the front electrode (4') of a second solar cell (10') when assembled;
t) providing a second solar cell (10') and connecting the back electrode (2) and/or electrically conductive carrier (1) of the first solar cell (10) via the conductive adhesive (9) with part (8') of the front electrode (4') of the second solar cell (10') and
u) optionally repeating steps i) to u) until the desired number n of solar cells is connected in series, wherein n is an integer between 2 and 250, preferably between 6 and 50;
v) optionally curing the series of electrically connected solar cells;
w) providing an electrical contact to the electrically conductive carrier (1) of the last solar cell in the connected series and providing an electrical contact to the electrically conductive carrier of the first solar cell in the connected series so that n-1 solar cells are active; and
x) optionally conducting an efficiency test and selecting connected series that pass the test.

In general the solar cells according to the invention may be prepared by a so-called roll-to-roll process which involves the use of long strip-like carriers which are processed in a quasi-continuous way by sequentially applying the additional layer up to the front electrode thereon with optional intermediate steps as described above.

### BRIEF DESCRIPTION OF THE DRAWINGS

Fig. 1 shows a cross-section of an embodiment of the strip-like solar cell of the invention in the direction perpendicular to the longitudinal axis of the solar cell with the front electrode being divided into three parts by two grooves along the side of the solar cell and two isolating structures in the form of isolators applied on top of the front electrode and on top of the electrically conductive carrier;
Fig. 2 shows a cross-section of a solar cell according to Fig. 1 at a different location than Fig. 1, in the direction perpendicular to the longitudinal axis of the solar cell with a shunt and three isolating structures;
Fig. 3 shows a top view of an embodiment of a part of the solar cell of the invention showing two grooves along the side of the solar cell and two isolating structures and a passivated shunt;
Fig. 4 shows a top view of an embodiment of a part of the solar cell of the invention before separating two solar cells by cutting along line C with four grooves and two isolating structures, wherein only the two solar cells are shown partially;
Fig. 4a shows another top view of an embodiment of a part of the solar cell of the invention before separating three solar cells by cutting along line C with four grooves and two isolating structures, wherein one solar cell is shown completely between the two cutting lines C and the other two solar cells are shown partially;
Fig. 5 shows a cross-section of an embodiment of a photovoltaic string assembly of the invention showing the assembly and serial connection in imbricate form of two solar cells according to Fig. 1;
Fig. 6 shows a cross-section of another embodiment of a photovoltaic string assembly of the invention showing the assembly of two solar cells according to Fig. 2;
Fig. 7 shows a top view of a string of solar cells forming a photovoltaic string assembly;

### DETAILED DESCRIPTION OF THE INVENTION

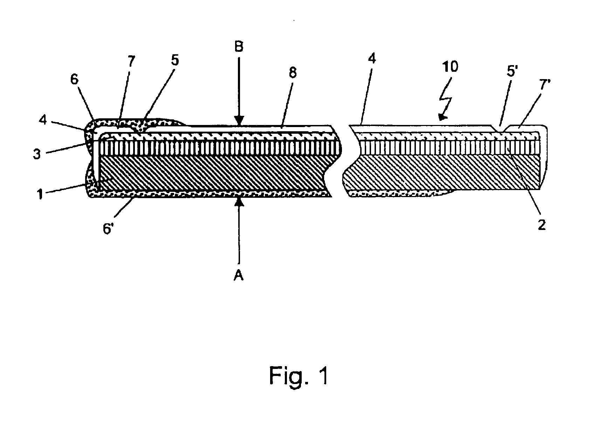

The general structure of the solar cells according to the invention is, starting from the lowermost side A as shown in Fig. 1 of the solar cell, an electrically conductive carrier 1, a back electrode 2, an absorber layer 3 forming the photoactive diode and on top B of the solar cell, a front electrode 4 in this sequence. Optionally, a buffer layer can be present between the absorber layer 3 and the front electrode 4. The incidence of light is from side B.

In the preferred embodiment according to **Fig. 1** the invention relates to a thin film solar cell 10 comprising an electrically conductive carrier 1, a back electrode 2 which is directly electrically connected to and located on top of said carrier 1, an absorber layer 3 and a front electrode 4. In the solar cell according to Fig. 1 the front electrode (4) is divided into three parts 7, 7', 8 by two grooves 5, 5' which are provided for electrically isolating at least part 8 of the front electrode 4 of the solar cell from the electrically conductive carrier 1 and the back electrode 2 and therewith obtaining at least one first part 8 of the front electrode 4 that is electrically isolated from the electrically conductive carrier 1 and the back electrode 2 of said solar cell and at least two second parts 7, 7' of the front electrode 4 that are electrically not isolated from the electrically conductive carrier 1 and the back electrode 2 of said solar cell. Additionally, the solar cell 10 contains two isolating structures 6, 6' which may be in the form of an isolating coating on top of the front electrode 4 and on top of the electrically conductive carrier 1. The isolating structure 6 on top of the front electrode 4 is capable of preventing direct electrical contact of the electrically conductive carrier 1 and the back electrode 2 of said solar cell 10 and an electrically conductive carrier 1' and/or a back electrode 2' of a second solar cell 10' (not shown in Fig. 1) intended to be brought into contact with the front electrode 4 of said solar cell 10 at at least that part of part 7 of the front electrode 4 that is electrically not isolated from the electrically conductive carrier 1 and the back electrode 2 of said solar cell 10. The isolating structure 6' on top of the electrically conductive carrier is capable of additionally preventing an undesired electrical contact between the electrically conductive carrier 1 of the solar cell 10 and the part of the front electrode of a second solar cell (not shown in Fig. 1) which is not isolated from the back electrode and the electrically conductive carrier of the second solar cell when brought into contact with the electrically conductive carrier of the solar cell according to Fig. 1. It is to be understood that the invention also relates to the case in which only groove 5 and/or one isolating structure 6 or 6' is provided. This may be the case if e.g. undefined structures would be present or expected at only one edge of the solar cell.

In a preferred embodiment of the invention the at least one isolating structure 6 covers at least part of the at least one second part 7 of the front electrode 4 that is electrically not isolated from the electrically conductive carrier 1 and the back electrode 2 of said solar cell 10.

In another preferred embodiment of the invention the at least one isolating structure 6 completely covers the at least one second part 7 of the front electrode 4 that is electrically not isolated from the electrically conductive carrier 1 and the back electrode 2 of said solar cell 10 and that is adapted to be brought into contact with the electrically conductive carrier (1') and the back electrode (2') of a second solar cell 10'.

In a further preferred embodiment of the invention the solar cell comprises an at least one additional isolating structure 6' being adapted for additionally preventing direct electrical contact of the electrically conductive carrier 1 and the back electrode 2 of said solar cell 10 and that part corresponding to part 7 of said solar cell of the front electrode 4 of a second solar cell that is electrically not isolated from the electrically conductive carrier and the back electrode of said second solar cell.

In an additional preferred embodiment at least one additional isolating structure 6' covers at least part of the electrically conductive carrier 1.

In another preferred embodiment at least one isolating structure 6 completely covers at least that part of the back electrode 1 of the solar cell 10 that is adapted to be brought into contact with that part of the front electrode corresponding to part 7 of the front electrode 4 of a second solar cell that is electrically not isolated from the electrically conductive carrier and the back electrode of said second solar cell. Additionally at least part of part 8 of the front electrode in Fig. 1 is intended to be brought into contact with the back electrode 2' and/or the conductive carrier 1' of the second solar cell 10' in order to provide an assembly in series of the two solar cells.

In a preferred embodiment of the solar cell 10 according to the invention, the electrically conductive carrier 1 comprises a material selected from the group consisting of metal strips, electrically conductive polymers, copper, stainless steel, steel, nickel, chromium, titanium, molybdenum and mixtures thereof. It is particularly preferred that the electrically conductive carrier 1 comprises copper, in particular it consist of copper. The electrically conductive carrier 1 is additionally flexible in order to provide a flexible solar cell produced there from.

In a preferred embodiment the solar cell 10 according to the invention comprises a back electrode 2 comprising a material selected from the group consisting of copper, indium, gallium, zinc, silver, nickel, molybdenum and mixtures thereof, in particular copper and indium. In a particular preferred embodiment, the solar cell comprises an electrically conductive carrier 1 comprising or consisting of copper onto which indium is applied by a galvanic process and therewith producing a layer of copper/indium. Thus an electrically conductive carrier 1 in direct electrical contact with a back electrode 2 is obtained. It is to be understood in the context of the invention that the electrically conductive carrier 1 and the back electrode 2 may, in a preferred embodiment, be formed in one layer.

In a preferred embodiment the solar cell 10 according to the invention comprises an absorber layer 3 comprising a material comprising Ib/IIIa/VIa element semiconductors, in particular wherein the Ib element is copper, the IIIa element is selected from the group consisting of Ga and In, in particular In, and the VIa element is selected from the group consisting of S and Se, in particular S. In a preferred embodiment, the absorber layer 3 comprises Cu/In/S. The absorber layer 3 may be formed by heating the laminate of the electrically conductive carrier 1 and the back electrode 2 and bringing the heated laminate into contact with sulphur vapor. In a particularly preferred embodiment, the absorber layer corresponds to the absorber layer as described in EP 1 052 702. In particular, the absorber layer 3 comprises a first polycrystalline, ternary phase of the n-conductive type and a second ternary phase of the p-conductive on the surface thereof which faces the incidence of light. In this preferred embodiment the absorber layer 3 shows a potential barrier in the volume.

In a preferred embodiment of the solar cell 10 according to the invention, the front electrode 4 comprises a transparent conductive oxide (TCO), preferably selected from the group consisting of ZnO, SnO and Indiumtinoxid (ITO), optionally doped with Al, Ga, and/or F.

In a preferred embodiment the solar cell 10 according to the invention comprises additionally between the absorber layer 3 and the front electrode 4 a buffer layer (not shown in Fig. 1) which preferably comprises a material comprising an n-semiconductor or an p-semiconductor, preferably selected from the group consisting of Ib/VII element, Ib/VIa elements, IIb/VIa elements, VII/VIa elements and mixtures thereof, in particular selected from the p-type group consisting of CuI, Cu₂₋ₓO, Cu₂₋ₓS, wherein x is between 0 to 1, or n-type group consisting of CdS, ZnS, ZnO Zn(OH) MnO and mixtures thereof.

In a particular preferred embodiment, the electrically conductive carrier comprises copper, the back electrode comprises copper and indium, the absorber layer comprises copper, indium and sulphur, the buffer layer comprises CuI and the front electrode ZnO. The solar cell 10 according to the invention is preferably in a strip-like form, in particular having a breadth from about 3 to about 400 mm, in particular about 5 mm to about 15 mm, preferably about 5 mm to about 8 mm, in particular 10 mm, in breadth and from about 0.1 m to about 3 km in length.

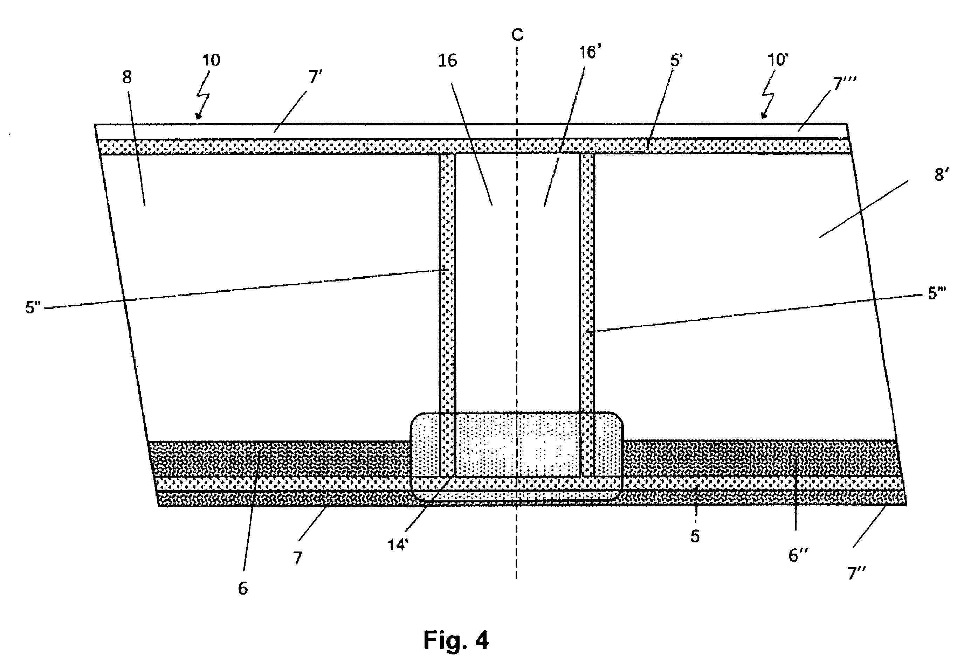

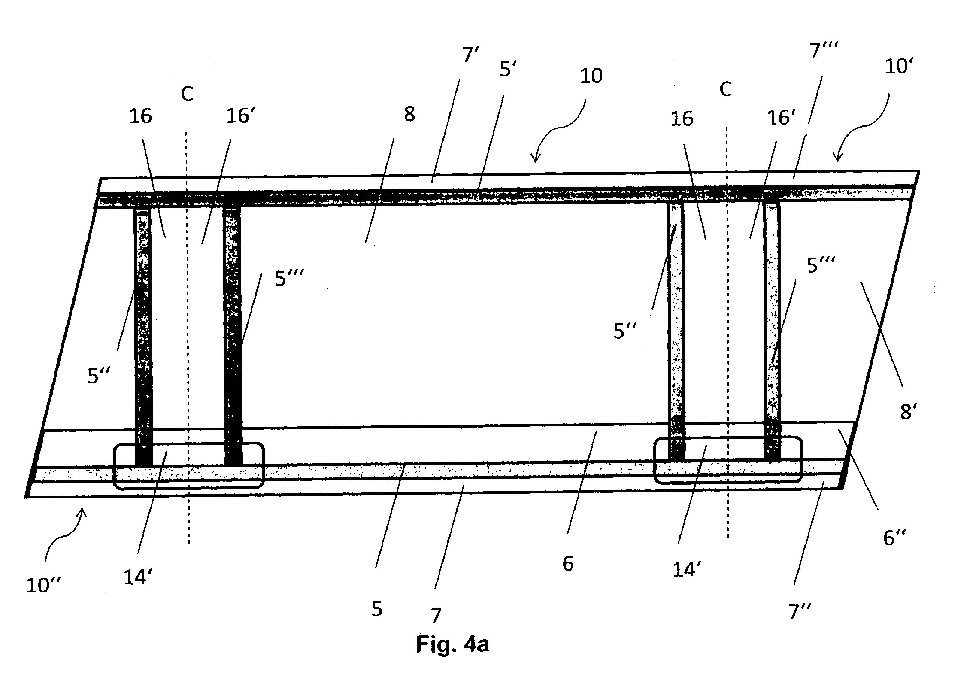

As shown in Fig. 1 the solar cell 10 according to the invention preferably comprises a groove 5 dividing the front electrode 4 of the solar cell 10 which is provided by partially removing the front electrode 4 near the edge of the solar cell so that there is no direct electrical contact between the part 7 and the part 8 of the front electrode 4 and therewith electrically isolating the part 8 of the front electrode 4 and the conductive carrier 1 together with the back electrode 2. As also shown in Fig. 1 it is preferred that the solar cell 10 according to the invention comprises two divisions of the front electrode 4 by two grooves 5 and 5' which are provided by partially removing the front electrode 4 near two opposite edges along the length of the solar cell 10 so that there is no direct electrical contact between the parts 7, 7' and the part 8 of the front electrode 4 and therewith electrically isolating the part 8 of the front electrode 4 and the conductive carrier 1 together with the back electrode 2. In a particularly preferred embodiment at least four grooves 5, 5', 5'', 5''' as can be seen in the top view of a solar cell in Fig. 4, which are provided by partially removing the front electrode 4 near all four edges of the solar cell 10 and along the sides of the solar cell. If the solar cell 10 according to the invention comprises a buffer layer, it is preferred that the division of the front electrode comprises that, in addition to the front electrode, the buffer layer is at least partially, preferably completely, removed.

A solar cell 10 according to the invention is preferred, wherein the front electrode 4 and, optionally the buffer layer, is removed in a distance from the edge of about 0.1 mm to about 3 mm over a breadth of about 20 µm to about 0.1 mm and along the side of the solar cell. Preferably, the removal of the front electrode 4 and, optionally, of the buffer layer, may be conducted with a laser and/or with chemical etching, in particular with a laser.

In a preferred embodiment and as shown in Fig. 1 the solar cell 10 according to the invention comprises at least one isolating structure 6 which is provided by partially applying an electrical isolator over that part 7 of the front electrode which is not isolated from the electrically conductive carrier 1 and the back electrode 2. Additionally according to Fig. 1 a second isolating structure 6' is provided covering at least part of the electrically conductive carrier 1. By providing the two structures 6, 6' the additional safety is provided in case two such solar cells 10 are assembled in an imbricate way that there is no undesired electrical contact between the solar cells over the part 7 of the front electrode that is not isolated from the electrically conductive carrier 1 and the back electrode 2. However, it is to be understood that the solar cell according to the invention may also only comprise one of the isolating structures 6, 6'. Further, the isolating structure 6 may be placed on top 6 of the front electrode 4, on top of the electrically conductive carrier 1 or at both positions as isolating structures 6, 6'.

The isolating structure(s) 6, 6' will prevent that the part(s) of the front electrode 7, 7' which are in electrical contact with the back electrode 2 and/or the electrically conductive carrier 1 will be contacted by a second solar cell which is brought into contact with the first solar cell. Therefore, it is preferred that the electrical isolator 6 is applied on top of the front electrode 4 over an area at least covering that part 7 of the front electrode 4 that is intended to be brought into contact with the electrically conductive carrier 1' and/or the back electrode 2' of a second solar cell 10'. "On top of the front electrode" in the sense of the invention means, as shown in Fig. 1, on the upmost side B of the solar cell 10. As shown in Fig. 1 it is not necessary to cover all parts 7, 7' with an electrical isolator. Only those parts 7 of the front electrode 4 of the first solar cell are preferably covered by the electrical isolator 6 which would create a short circuit due to its contact with the back electrode and/or electrically conductive carrier when the first solar cell will be brought into electrical contact with a second solar cell.

The isolating structures 6, 6' will preferably be applied along the edge of the solar cell at a breadth of from about 0.1 mm to about 9 mm along the side of the solar cell, in particular if applicable at a breadth to cover part 7 of the front electrode 4. The structures 6, 6' may also extend over at least part of the side of the solar cell 10.

The isolating structure is preferably selected from the group consisting of an electrically isolating inorganic coating and an electrically isolating organic coating, preferably an inorganic coating containing SiO₂. In another preferred embodiment the solar cell 10 according to the invention the solar cell 10 is provided with at least two isolating structures 6, 6' by partially applying a first electrical isolator 6 on top of the front electrode 4, at least partially or completely over part 7 and a second electrical isolator 6' at least partially on top of the electrically conductive carrier 1 such that at least part of the conductive carrier 1 and the part 8 of the front electrode will still be adapted to be contacted. "On top of the electrically conductive carrier" in the sense of the invention means, as shown in Fig. 1 on the lowermost side A of the solar cell 10. Additionally, the electrical isolators 6, 6' may extend over the edge onto the side of the solar cell. In Fig. 1 this embodiment is shown. This embodiment is preferred since the two isolating structures in form of e.g. the electrical isolators 6, 6' are applied such that, when the solar cells are assembled into a module, both isolators will come into direct contact and be adjacent to each other and therewith provide a double safety for preventing any undesired electrical contact between two solar cells.

Preferably, the electrical isolator to be used to provide the isolating structure(s) is selected from the group consisting of electrically isolating inorganic coating and electrically isolating organic coating, preferably an inorganic coating containing SiO₂.

In another embodiment, the solar cell 10 is provided by at least partially removing at least part of part 7 of the front electrode 4. This embodiment is not shown in Fig. 1. In order to safeguard that no undesired electrical contact between two solar cells will occur, it is also possible to remove those parts of the front electrode that are in contact with the electrically conductive carrier and/or the back electrode. Therewith the electrically conductive carrier and/or the back electrode of a second solar cell brought into contact with the front electrode of the first solar cell will not come into contact with any structure that might cause a short circuit with the back electrode of the first solar cell.

Preferably the front electrode 4 is removed at the edge of the solar cell over a breadth of about 20 µm to about 3mm. The removal of the front electrode 4 may be conducted with a laser. In a particularly preferred embodiment, it is also possible to first remove those part(s) 7 of the front electrode 4 which are in direct contact with the electrically conductive carrier and/or the back electrode over the edge or side of the first solar cell and which are intended to be brought into contact with the electrically conductive carrier and/or the back electrode of a second solar cell and then apply as at least one isolating structure(s) 6, 6' as described above at these locations. Preferably, the removal of the part(s) 7 of the front electrode 4 can be conducted by chemical etching and/or by cutting off the edge or side of the solar cell 10 in a way that an inclined area or surface is obtained through the front electrode and possibly also through the buffer layer 3 and/or absorber layer 2.

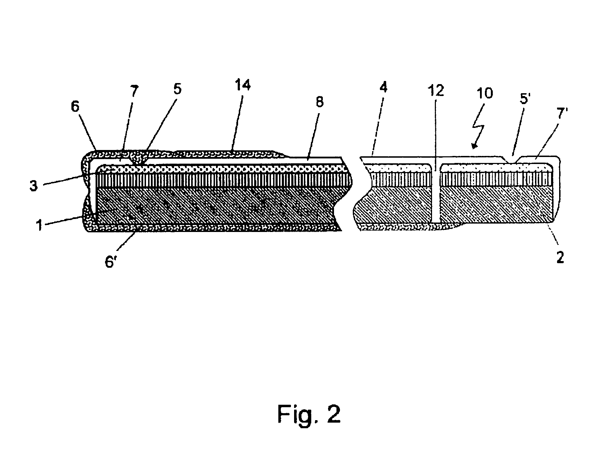

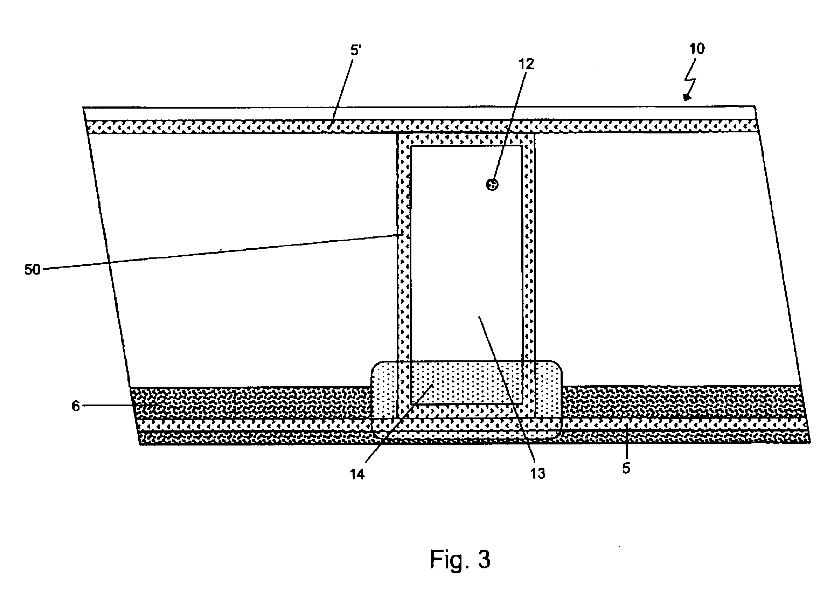

As shown in an embodiment of the solar cell 10 in **Fig. 2** and **Fig. 3****,** due to manufacturing variation, the solar cell 10 may contain locations 12, also called shunts, on top of the solar cell B and extending to the back electrode 2 and/or the electrically conductive carrier 1 where the front electrode 4 is in direct electrical contact with the back electrode 2 and/or the electrically conductive carrier 1. By this contact the efficacy of the solar cell 10 is impaired since these locations cause a short circuit there. Such locations are also called shunts. In a preferred embodiment the at least one shunt 12 is therefore passivated in the solar cell. The passivation of a shunt 12 is preferably conducted by electrically isolating the area 13 of the front electrode 4 around the shunt 12 from the remaining front electrode 4. Such isolation may be conducted by an at least partial removal of the front electrode around the location of the shunt 12 along the line or groove 50 which may be in rectangular form as shown in Fig. 3. The isolation may also be achieved in conducting at least partial removal along two lines around the shunt 12 which connect the structures 5, 5' so that the area 13 around the shunt is again isolated from the remaining part 8 of the front electrode 4. The isolation may take any form as long as it is safeguarded that the shunt will be electrically isolated from the remaining front electrode 4, in particular part 8 thereof.

The solar cell 10 as shown in a preferred embodiment in Fig. 2 and Fig. 3 comprises least one additional isolating structure 14 in order to prevent direct electrical contact of the electrically conductive carrier 1 and the back electrode 2 of said solar cell 10 and an electrically conductive carrier 1' and/or a back electrode 2' of a second solar cell 10' intended to be brought into contact with the front electrode 4 of said solar cell 10 at at least that part of an area 13 on top B of the front electrode around the location of a shunt 12
- that is electrically not isolated from the electrically conductive carrier 1 and the back electrode 2 of said solar cell 10 and
- that is intended to be brought into contact with the electrically conductive carrier 1' and/or the back electrode 2' of the second solar cell 10'.

The isolating structure 14 is preferably made of the same material as described with relation to the isolating structure 6, 6' above.

In a preferred embodiment a method for localizing defects, such as shunts 12, causing leakage currents is conducted with the solar cell (10), comprises illuminating an area, having at least a minimum size, of the photovoltaic element, determining a position of a defect based on at least one photoinduced electrical value of an electrical potential between electrodes of the photovoltaic element and a corresponding measurement position within the illuminated area on one of the electrodes of the photovoltaic element, and removing at least one of the electrodes in an area at the determined position of the defect via etching. Preferably, the etching is performed via laser etching but may also be performed by chemical etching, pad printing and or jet printing. The at least one of the electrodes may be removed along a line (5) with a predetermined width by a laser in the area at the determined position thereby electrically isolating the defect.

Additionally, two or more defects for which the positions have been determined and which positions are next to each other can be identified as a cluster of defects. Then, the line with the specific width is preferably drawn around the cluster of defects via laser etching.

A method for passivating a shunt in a photovoltaic element may include a front electrode, such as a TCO layer. Optionally, the buffer layer may be removed along with the front electrode. This method comprises determining a position of a shunt in the photovoltaic element, positioning the photovoltaic element at the determined position and removing the front electrode in an area at the determined position of the shunt thereby ensuring that the shunt has no electrical contact to the front electrode after removing the front electrode. Preferably, the front electrode is only partially removed around the shunt. Furthermore, the etching is preferably performed via laser etching and the front electrode around the determined position of the shunt is removed along a line with a predetermined width by a laser thereby electrically isolating the shunt. Alternatively, the etching may be performed via chemical etching.

**Fig. 4** shows another embodiment of a quasi endless solar cell of the invention in strip-like form which contains part of two solar cells 10, 10' in top view which are to be cut along the cutting edge C. **Fig. 4a** also shows another embodiment of a quasi endless solar cell of the invention in strip-like form which contains part of three solar cells 10, 10', 10" in top view which are to be cut along the cutting edges C. The solar cells are provided with grooves 5, 5' and 5" and 5'''. If the solar cells 10, 10' are cut along cutting edge C the front electrode due to its low hardness may "smear" over the edge and side of the solar cells 10, 10' at the cutting edge C and therewith causing short circuits within the solar cells as described above. Therefore, in the embodiment according to Fig. 4 the sides along the cutting edges C are also provided with grooves 5'' and 5"'.

Even though only part of the solar cells is shown, the not shown part of solar cells 10, 10' or 10" may also contain cutting edges which include the corresponding grooves 5" and 5'''.

The reference signs for solar cells 10, and 10' are as explained in Fig. 1 to 3 and 6.

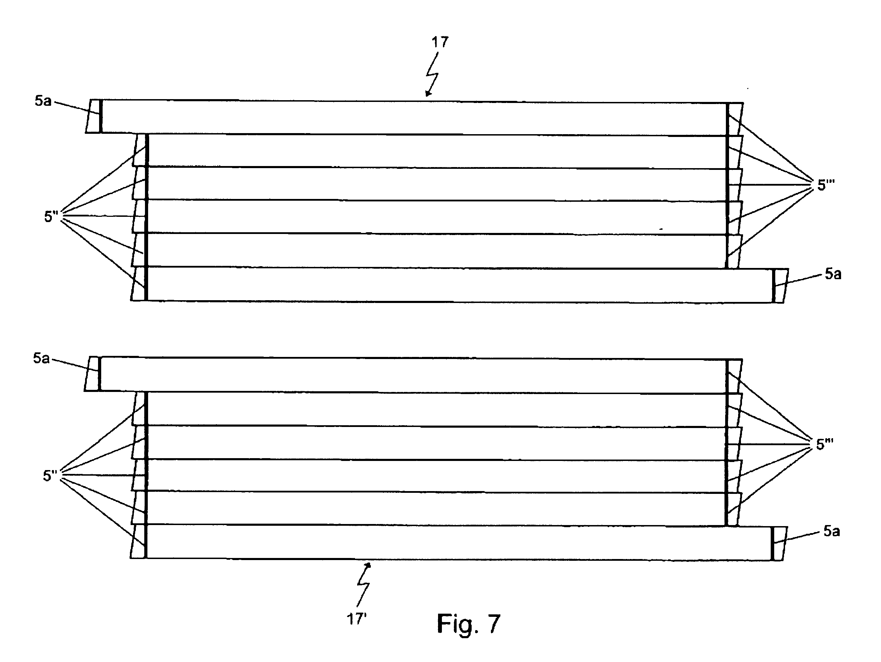

As the solar cells according to the invention are preferably produced in a reel-to-reel or roll-to-roll technology producing quasi endless band of solar cells which need to be separated or cut into discrete solar cells, the solar cells of the invention will preferably contain four grooves 5, 5', 5" and 5''' along all side of the solar cell, since the problem of short circuits over the edges or sides may occur at each side thereof, may it be because of the cutting or because of the manufacturing process. The four grooves 5, 5', 5" and 5''' are preferably provided for by the partial removal of the front electrode 4 along the sides of the solar cell in form of lines as already described above. Grooves 5" and 5''' may additionally serve as cutting marks as explained in relation to Fig. 7 below.

The embodiment according to Fig. 4 or 4a, as with Fig. 3 additionally shows an isolating structure 14' in order to prevent direct electrical contact of the electrically conductive carrier 1 and the back electrode 2 of said solar cell 10 and an electrically conductive carrier 1' and/or a back electrode 2' of a second solar cell 10' intended to be brought into contact with the front electrode 4 of said solar cell 10. In Fig. 4 and 4a contact is prevented with area 16 on top B of the front electrode bordered by grooves 5, 5' and 5" and the edge or side of the solar cells 10 after cutting the two solar cells apart. The same is true for a solar cell 10' in which an area 16' is produced by the cutting along cutting edge C and the area 16' is bordered by grooves 5, 5' and 5''' and the edge or side of the solar cells 10 after cutting the two solar cells apart.

The embodiment according to Fig. 4 additionally shows an isolating structure 6 which will prevent short circuits between two solar cells when assembled. In the embodiment of Fig. 4 short circuits are prevented when the solar cells are assembled in imbricate form. In this form, as described in more detail below, the back electrode and/or the electrically conductive layer of one electrode is connected to the front electrode of a second solar cell. The function of structure 6 is already explained in detail with relation to Fig. 1. Structure 14' in Fig. 4 serves the purpose that the second solar cell will additionally not come into electrical contact with area 16 of the front electrode. This area 16 of the front electrode may still be in direct electrical contact with the back electrode and/or the electrically conductive carrier when cut along line C due to "smearing" of the front electrode over the side. If a second solar cell would be brought into electrical contact with area 16 this might cause a short circuit between two solar cells.

In a particularly preferred embodiment of the invention, the solar cell will therefore comprise an electrically conductive carrier 1, a back electrode 2, an absorber layer 3 possibly a buffer layer and on top of the solar cell, a front electrode in this sequence, wherein the layers are preferably as described above. Additionally, the solar cell in this embodiment will comprise four grooves 5, 5', 5" and 5''' along and near all four sides or edges of the solar cell as shown in Fig. 4 and 4a, in particular provided by removal of the front electrode, four isolating structures, a first one 6 on top of the front electrode along one side of the solar cell which will be brought into contact with a second solar cell, a second one 6' on the lowermost side of the solar cell, i.e. on top of the electrically conductive carrier at least on those areas of the conductive carrier which will be brought into contact with that areas 7 of a second solar cell which is not electrical isolated from the back electrode of said solar cell, and a third and fourth one 14, 14' on those areas of the front electrode which are still in contact with the electrically conductive carrier and/or the back electrode, either through a shunt or through the cutting edges, and which will be brought into contact with a second solar cell.

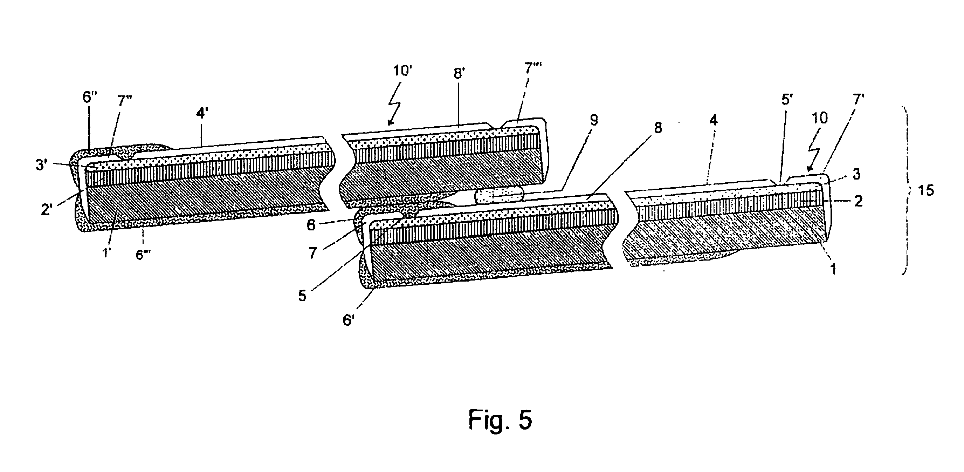

**Fig. 5** shows a cross section of the solar cells 10, 10' of the invention which are assembled into a photovoltaic module 15. In the second solar cell 10' the respective means in the first solar cell 10 are designated with the corresponding numbers, with the addition of one or more '. In the preferred embodiment shown in Fig. 5 a photovoltaic module 15 of the invention comprises at least two solar cells 10, 10' electrically connected in series, wherein the front electrode 4 over the part 8 thereof which is electrically isolated from the back electrode 2 and the electrically conductive carrier 1 of a first solar cell 10 is connected to the electrically conductive carrier 1' and therewith to the back electrode 2' of a second solar cell 10'. Additionally, any undesirable electrical contact is prevented by two grooves 5, 5' incorporated by removal of the front electrode 4 along the edges of the solar cell 10 in form of lines or ditches and by two isolating structures 6, 6'''. Part 8 of the front electrode 4 is not in contact with parts 7, 7' of the front electrode 4 at the edges and sides of the solar cell 10 any more.

In a preferred embodiment in order to ensure a safe and reliable electrical contact between the front electrode 4 of a first solar cell 10, in particular over part 8 of the front electrode, and the electrically conductive carrier 1' of a second solar cell 10' and, therewith also to back electrode 2' of a second solar cell 10', a conductive adhesive 9 is provided between the front electrode 4, in particular part 8 thereof, and the electrically conductive carrier 1' of the second solar cell 10'. The conductive adhesive 9 is preferably provided for in a line along the edge of the solar cell adjacent to the structures 5 and 6. Therewith the major part of the front electrode 4, in particular part 8 thereof, is left uncovered by the second electrode 10' and can serve its purpose to allow the incidence of light from side B in order to arrive at the absorber layer 3 where electrical energy is produced.

The conductive adhesive 9 is preferably an electrically isotropic or anisotropic conductive organic resin, in particular a metal filled epoxy resin, wherein the metal is in particular selected from the group consisting of Au, Ag, Cu, and Ni or C.

The photovoltaic module 15 according to the invention will comprise a number of solar cells 10, 10' which are reasonable for the intended use. A photovoltaic module 15 may e.g. comprise at least 10, preferably at least 40, and in particular at least 50 solar cells 10, 10', and up until 150, preferably 100, and in particular at least 80 solar cells 10, 10'. In the photovoltaic module 15 the solar cells are preferably electrically connected in series and assembled in imbricated form. Preferably, the solar cells 10, 10' in imbricated arrangement overlap along their sides about 0.05 cm to about 1 cm.

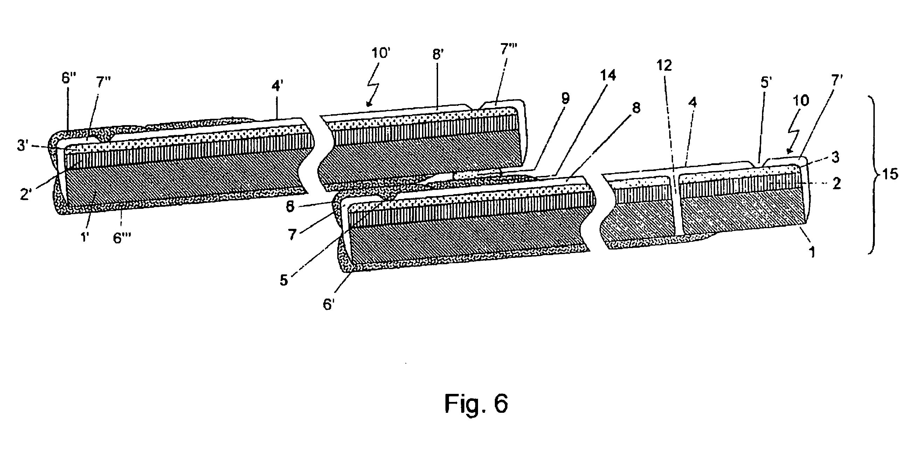

As shown in **Fig. 6** in a preferred embodiment of a photovoltaic module, the solar cell 10 additionally contains a further isolating structure 14 which will prevent that the area 13 around a shunt 12 will be electrically contacted by a second solar cell 10' brought into contact therewith as described with relation to Fig. 3. Structure 14 is preferably provided over at least the area 13 around shunt 12 which will be brought into contact with a second solar cell 10' when assembled.

If the electrically conductive carrier 1' and/or the back electrode 2' of a second solar cell 10' would be brought into contact with area 13, then a direct electrical contact would be created over the shunt 12 with the electrically conductive carrier 1 and/or the back electrode 2 of the first solar cell 10, therewith causing a short circuit. Therefore, the isolating structure 14 will prevent that area 13 is electrically contacted with a second solar cell and therewith prevents short circuits between solar cells when assembled into modules.

It would not be necessary in order to prevent the occurrence of short circuits between two solar cells when assembled into modules to provide a conductive adhesive 9 as shown in Fig. 6. However, since the conductive adhesive 9 is preferably applied in one step over the whole length of the solar cell, the conductive adhesive 9 may also be present at these locations. The presence of the conductive adhesive 9 does not impair the function of isolating structure 14 to prevent a short circuit between the solar cells.

**Fig. 7** shows two string assemblies 17, 17' each composed of six solar cells in accordance with an embodiment of the present invention. For both string assemblies 17, 17' the first solar cell and the last solar cell are longer than the other four solar cells. The first solar cell extends on the one side of the string assembly 17 and the last solar cell extends on the other side of the string assembly 17. The first solar cell of string assembly 17 extends on one side in order to be interconnected by a bus bar on the conductive carrier and /or back electrode with the conductive carrier and /or back electrode of a first solar cell of another string. The last solar cell of this string assembly 17 extends on the other side in order to be interconnected by another bus bar on the conductive carrier and /or back electrode with the conductive carrier and or back electrode of a last solar cell of another string 17'. Five of six solar cells at every string assembly will be active in accordance with an embodiment of the present invention.

Alternatively, the strings may consist not only of six solar cells, but any number of solar cells desired. Furthermore, the last electrode is interconnected alternatively on the front electrode and the first electrode is alternatively interconnected on the back electrode. Additionally, not only two strings may be interconnected but any desired number of strings.

Furthermore, Fig. 7 shows specific cutting marks 5" and 5'''. These marks result from cutting the solar cell obtainable by a roll-to-roll technology and still in a long strip-like form into separate solar cells. In order to cut the solar cell at the desired positions needed for the production of the string assemblies so called cutting marks are created on one of the electrodes of the solar cell. Preferably, the cutting marks are created on the front electrode of the solar cell. In a particular preferred embodiment, the cutting marks 5" and 5''' may at the same time serve as grooves in order to divide the front electrode into parts as described above.

Thus, the cutting marks according to one embodiment of the present invention are applied to front electrode in a way that they not only show and mark the position for cutting the solar cell but also to electrically disconnect the cut side of the solar cell from the remaining part 8 of the front electrode.

Preferably, the cutting mark for indicating where the solar cell which is still in a long strip-like form has to be cut has a similar shape as the structure for passivating the detected shunt. Preferably the marks/structures for passivating the detected shunt and for cutting the solar cell differ in its width. This means that e.g. a rectangular form is for passivating detected shunts and for indicating where the solar cell has to be cut. However, the width of the rectangular form used varies in accordance with its function to be used. For example the rectangle for passivating a detected shunt has a first specific width and the rectangle for indicating a cutting mark has a second specific width which differs from that for passivating a shunt.

Furthermore, as the first and the last solar cell of a string assembly are preferably longer than the other solar cells in the string assembly the cutting marks 5a for the first and the last solar cell in a string may differ in width from that of a cutting mark for the second and other solar cell in a string.

In that way it can be automatically detected whether there is an area of a passivated shunt, a cutting mark of a first, a second, a subsequent or a last solar cell for a string.

The detection of the respective marks may be performed by the aforementioned method for detecting shunts.

In a preferred embodiment the solar cell of the invention may be manufactured by a process comprising the steps of
a) providing a solar cell (10) comprising an electrically conductive carrier (1), a back electrode (2), an absorber layer (3), optionally an buffer layer on top of the absorber layer and a front electrode (4);
b) dividing the front electrode (4) into at least two parts (7, 8) for electrically isolating at least one part (8) of the front electrode (4) of the solar cell from the electrically conductive carrier (1) and the back electrode (2) and providing at least one second part (7) of the front electrode (4) that is electrically not isolated from the electrically conductive carrier (1) and the back electrode (2) of said solar cell, or preferably dividing the front electrode (4) optionally into at least four parts (7, 7', 8, 16) for electrically isolating at least two parts (8, 16) of the front electrode (4) and providing at least two parts (7, 7') of the front electrode (4) that are electrically not isolated from the electrically conductive carrier (1) and the back electrode (2) of said solar cell and
c) providing an at least one isolating structure (6) in order to prevent direct electrical contact of the electrically conductive carrier (1) and the back electrode (2) of said solar cell and an electrically conductive carrier (1') and the back electrode (2') of a second solar cell (10') brought into contact with the front electrode (4) of said solar cell (10).

Preferably, the method for manufacturing the solar cells of the invention additionally comprises providing at least two grooves 5, 5' in particular at least four grooves 5, 5', 5" and 5''', for electrically isolating at least part of the front electrode 4 of the solar cell from the electrically conductive carrier 1 and back electrode 2 by at least partially removing the front electrode 4 along two opposite edges of the solar cell and providing at least two isolating structures in particular at least four 6, 6', 14', in order to prevent direct electrical contact of the electrically conductive carrier 1 of said solar cell and an electrically conductive carrier 1 of a second solar cell brought into contact with the front electrode 4 of said solar cell.

The invention additionally relates to a solar cell obtainable according to the methods of the invention.

Finally, the invention relates in a preferred embodiment to a method of producing a module assembly comprising at least two solar cells according of the invention comprising
i) providing a first solar cell (10) by conducting a process comprising the steps of
i1) providing an electrically conductive carrier (1), in particular of copper reel, 1 cm in width, 100µm in thickness and 2000 m length;
i2) optionally cleaning the electrically conductive carrier (1), in particular by chemically cleaning and/or electrochemically etching followed by some rinsing processes;
i3) applying a back electrode (2) on the conductive carrier (1), in particular by one sided electrochemically plating of Indium resulting in an Cu-In back electrode by interdiffusion of the metals; The thickness of the In-layer is preferably in the range of 0.7 µm with a homogeneity of the In-layer thickness of ± 5%;
i4) applying an absorber layer (3) on the back electrode (2) and optionally removing material not being part of the absorber layer on the surface and optionally annealing the absorber layer (3), in particular by forming a solid Cu-In-S layer by partial conversion of the Cu-In layer in reactive gaseous sulphur atmosphere at appr. 600 °C for 10 sec. following by chemical etching of the tape;
i5) optionally applying a buffer layer on the absorber layer (3) and optionally cleaning the surface of the buffer layer, in particular by spraying a wide band gap p-type CuI buffer layer from an acetonitrile - CuI solution with a thickness of about 50 nm following by some rinsing and drying processes;
i6) applying a front electrode (4) on the absorber layer or, if present, the buffer layer, in particular by deposition of a TCO stack using DC sputtering processes; At first an intrinsic layer of a thickness of approx. 50 nm is preferably deposited followed by the deposition of a high conductive layer with a thickness of approx.1 µm from an 2% Al doped ZnO target; The conductivity may be adapted by means of variation of the sputtering conditions;
i7) optionally cleaning the electrically conductive carrier (1), in particular by chemical etching following by some rinsing and drying processes;
j) dividing the front electrode (4) into at least two parts (7, 8) by removing parts of the front electrode (4) along at least one edge, preferably by partially removing TCO layers via laser;
   in particular optionally dividing the front electrode (4) into at least five parts (7, 7', 8, 16, 16') provided by grooves (5, 5' and 5" and 5''') preferably by partially removing the front electrode, preferably the front electrode and the buffer layer, if present, via laser
k) optionally passivating at least one shunt (12) by removing parts of the front electrode at the area of the shunt (12), in particular by drawing a line with a width of at least 50 µm around the determined shunt via laser etching wherein along the line the front electrode (4), in particular the TCO layer and optionally the buffer layer, if present, is removed thereby ensuring that after the step the front electrode (4) electrically in contact with the shunt has no electrical contact to the remaining front electrode (4) used as an electrode, therewith creating at least one part of the front electrode (13) which is located around the shunt and isolated from the rest of the front electrode (4);
l) optionally removing at least part of part (7) of the front electrode (4) in order to eliminate an electrical contact between part (7) of the front electrode and the back electrode and/or the electrically conductive carrier;
m) optionally removing particles and superficial parts of the buffer layer from the surface of the solar cell, such as by ultrasonic cleaning in particular removing the buffer layer from the grooves (5, 5', 5'', 5"', 50) so that the absorber layer is showing;
n) applying at least one isolating structures (6) by applying at least one electrical isolators on top of the front electrode (4) on to at least part (7), in particular by partially printing an inorganic sol-gel liquid on top of the front electrode following by drying and curing processes for some seconds to form an solid isolating layer;
o) optionally applying at least one additional structure (6') by applying at least one electrical isolator on top of the back electrode (2) and/or the electrically conductive carrier (1), in particular by partially printing an inorganic sol-gel liquid on top of electrically conductive carrier following by drying and curing processes to form an solid isolating layer;
p) optionally applying at least one additional structure (14) by applying at least one electrical isolator at least on top of the part 13 of the front electrode (4) in particular by partially printing an inorganic sol-gel liquid at least on top of the part (13) of front electrode following by drying and curing processes to form an solid isolating layer;
q) optionally applying at least one additional structure (14') by applying at least one electrical isolator at least on top of the part 16 of the front electrode (4) in particular by partially printing an inorganic sol-gel liquid at least on top of the part 16 of front electrode following by drying and curing processes to form an solid isolating layer;
r) providing an at least one electrically non-conductive sheet of high optical transmission and applying a first solar cell (10) with its front electrode thereon;
s) applying a conductive adhesive (9) on part of the back electrode (2) and/or electrically conductive carrier (1) which will be brought into electrical contact with that part (8') of the front electrode of a second solar cell (10') which is electrically isolated from the electrically conductive carrier (1') and the back electrode (2') of the front electrode (4') of a second solar cell (10') when assembled, preferably by using a printing process;
t) providing a second solar cell (10') and connecting the back electrode (2) and/or electrically conductive carrier (1) of the first solar cell (10) via the conductive adhesive (9) with part (8') the front electrode (4') of the second solar cell (10'), in particular by applying the second solar cell (10') in imbricated form partly with its front electrode at the non -conductive sheet of high optical transmission and partly with its front electrode at the back electrode of the first solar cell (10) to build a photovoltaic string assembly;
u) optionally repeating step i) to u) until the desired number n of solar cells is connected in series, wherein n is an integer between 2 and 250, preferably between 6 and 50;
v) optionally curing the series of electrical connected solar cells, in particular in a vacuum lamination process for 10 to 30 min at 110°C to 170 °C,
w) providing an electrical contact to the electrical conductive carrier (1) of the last solar cell in the connected series and providing an electrical contact to the electrically conductive carrier of the first solar cell in the connected series, in particular using a soldering process, so that n-1 solar cells will be active; and
x) optionally conducting an efficiency test and selecting connected series that pass the test.

In general it is preferred that the method of the invention be conducted in order to produce in a reel-to-reel process a quasi endless strip-like CIS-type thin-film solar cell. The dimensions thereof are as described above.

In a preferred embodiment, steps (i-2) to (i-3) may preferably be conducted by tape cleaning and In deposition as follows. In the first roll-to-roll process, the Cu tape of 1 cm in width is chemically cleaned followed by some rinsing processes. Then Indium is electrochemically deposited on the front side of the tape only. This takes into account that it is the In surface where the CIS starts to grow. The thickness of the In-layer is in the range of 0.7 µm. The homogeneity of the In-layer thickness of ± 5% is due for local stationary starting conditions and precursor properties, especially the homogeneous Cu-concentration.

Step (i-4) may preferably be conducted in that the absorber layer is provided by sulphurization as follows. A solid Cu-In-S layer is formed by partial conversion of the In-Cu precursor into the CISCuT-absorber when the tape is exposed to reactive gaseous sulphur inside a sulphurization reactor. After this process a Cu back side carrier a Cu-In back electrode and the CISCuT Absorber layer is formed. The dynamic of the reel-to-reel process on a tape substrate is connected with stationary thermal and chemical conditions at each place of the whole reactor by computer assisted control of the basic essential technical parameter as tape velocity, heater temperatures, pressure and nitrogen flow (Winkler et al., 2001).

The removal of the material not part of the absorber layer can preferably be conducted by KCN-etching as follows. Generally, the absorber layer surface may be treated with a KCN-solution to remove Cu₂-Sₓ from the surface. When contacting the absorber electrically, this device shows spontaneously a diode characteristic. The I-V- characteristic of such device can be measured using a graphite pad as front electrode, which contacts directly the etched surface of the absorber. The back side electrode is the Cu-tape.

The annealing can preferably be conducted as follows: The tape will be annealed on spool at moderate temperatures for 30 minutes.

Step (i-5), if conducted namely the buffer layer deposition, may preferably be conducted as follows. A wide band gap p-type CuI buffer layer with a thickness of about 50 nm is obtained by spraying CuI dissolved in acetonitrile (0.4 g in 80 ml) onto the absorber surface at a temperature of about 80°C.

Step (i-6) may preferably be conducted by TCO deposition as follows. A TCO stack is deposited by DC sputtering as a transparent front contact. At first an intrinsic layer of a thickness of 100 nm is deposited followed by the deposition of a high conductive layer with a thickness of 1 µm. The conductivity has been changed by means of variation of the oxygen pressure during the sputtering process. The target is 2% Al doped ZnO, the temperature of the tape is 165°C, thus achieving a transmittance of about 90%.

Step (j) may preferably be conducted by applying at least one groove (5) by removing parts of the front electrode (4) along at least one edge thereof by the use of a laser etching as described above;

Step (1) if conducted, may preferably be conducted by passivating at least one shunt (12) by removing parts of the front electrode around the shunt (12) as described above.

Step (m) if conducted, may preferably be conducted by removing at least part (7) of the front electrode (4) in that an inclined area is obtained extending through the front electrode and possibly partially through the buffer layer and possibly even through the absorber layer. The cutting off of the edge to an inclined area along the solar cell is preferably conducted along the side of the solar cells where on of the structures (5) has already been applied and where the connection with the next solar cell is intended when the module assembly is conducted. The cutting off of the edge is preferably conducted with a mechanical rubber.

Step (n) may preferably be conducted as follows. The particles and optionally the absorber layer showing in the grooves may be removed by laser;

Steps (o) and (p) may preferably be conducted as follows. The edges of the tape may be covered by an insulating glassy layer of nanomere solution, preferably as described above with relation to the isolator, to allow the roof tile interconnection during module assembling in the end;

Step (q) and (r) if conducted may preferably be conducted by applying at least one additional isolating structure (14) and / or (14') on top of part (13) and / or part (16) of the front electrode (4) by an insulating glassy layer of nanomere solution, preferably as described above with relation to the isolator, to allow the roof tile interconnection during module assembling in the end;

Steps (s) to (x) relating to the string assembly may preferably be conducted as follows. In an automated assembly line a defined number of stripes of the quasi-endless flexible tape may be imbedded into the front side foil and electrically connected in series "roof tile like", by overlapping. The overlapped region may be in the range of 1 mm. As contacting material metal filled glues may be used. Current collection grids at the transparent front side contact may be unnecessary. The roof tile interconnection of solar cell stripes to strings of defined voltage (number of stripes), of defined current (length of stripes), and the interconnection of the strings in parallel by using bus bars with definition of output power works, as described previously as a concept (Güldner et al., 2000). Front and back side encapsulated into function foils, flexible modules are obtained which are adaptable in output power, shape and size.

Step (y) if conducted may preferably be conducted by applying an efficiency test and selecting connected series that pass the test.

## Claims

1. A thin film solar cell (10) comprising an electrically conductive carrier (1), a back electrode (2) which is directly on top of said carrier (1), an absorber layer (3) and a front electrode (4) wherein the front electrode (4) is divided into at least two parts (7, 8) wherein at least one part (8) of the front electrode (4) of the solar cell is isolated from the electrically conductive carrier (1) and the back electrode (2) and at least one second part (7) of the front electrode (4) that is electrically not isolated from the electrically conductive carrier (1) and the back electrode (2) of said solar cell.

2. The solar cell (10) according claim 1, additionally comprising at least one isolating structure (6) being adapted for preventing direct electrical contact of the electrically conductive carrier (1) and the back electrode (2) of said solar cell (10) and an electrically conductive carrier (1') and/or a back electrode (2') of a second solar cell (10') adapted to be brought into contact with the front electrode (4) of said solar cell (10) at at least part of that part (7) of the front electrode (4) that is electrically not isolated from the electrically conductive carrier (1) and the back electrode (2) of said solar cell.

3. The solar cell (10) according to any one of the preceding claims, wherein the solar cell is in a strip-like form.

4. A photovoltaic string assembly (15) comprising at least two solar cells (10, 10') according to any of the preceding claims electrically connected in series, wherein at least part (8) of the front electrode (4) of a first solar cell (10) that is electrically isolated from the electrically conductive carrier (1) and the back electrode (2) of said solar cell is connected to the electrically conductive carrier (1') and/or the back electrode (2') of a second solar cell (10').

5. The photovoltaic string assembly (15) according to claim 4, wherein said at least part (8) of the front electrode (4) of a first solar cell (10) is connected to the electrically conductive carrier (1') and/or back electrode (2') of a second solar cell (10') by a conductive adhesive (9).

6. The photovoltaic string assembly (15) of any one of claims 4 or 5, wherein at least 40 solar cells according to any one of claims 1 to 3 are connected in series.

7. A method of manufacturing a solar cell (10) according to any one of claims 1 to 3 comprising the steps of
a) providing a solar cell (10) comprising an electrically conductive carrier (1), a back electrode (2), an absorber layer (3) and a front electrode (4);
b) dividing the front electrode (4) into at least two parts (7, 8) for electrically isolating at least one part (8) of the front electrode (4) of the solar cell from the electrically conductive carrier (1) and the back electrode (2) and providing at least one second part (7) of the front electrode (4) that is electrically not isolated from the electrically conductive carrier (1) and the back electrode (2) of said solar cell and,
c) optionally providing an at least one electrically isolating structure (6) in order to prevent direct electrical contact of the electrically conductive carrier (1) and the back electrode (2) of said solar cell and an electrically conductive carrier (1') and the back electrode (2') of a second solar cell (10') brought into contact with the front electrode (4) of said solar cell (10).

8. A solar cell (10) obtainable according to the method of claim 7.

9. Method of producing a photovoltaic string assembly comprising at least two solar cells according to any one of claims 1 to 3 comprising
i) providing a first solar cell (10)) according to any one of claims 1 to 3 by conducting a process comprising the steps of
i1) providing an electrically conductive carrier (1);
i2) optionally cleaning the electrically conductive carrier (1);
i3) applying a back electrode (2) on the conductive carrier (1);
i4) applying an absorber layer (3) on the back electrode (2) and optionally removing material not being part of the absorber layer on the surface and optionally annealing the absorber layer (3);
i5) optionally applying a buffer layer on the absorber layer (3) and optionally cleaning the surface of the buffer layer; and
i6) applying a front electrode (4) on absorber layer or, if present the buffer layer and
i7) optionally cleaning the electrically conductive carrier (1);
j) dividing the front electrode (4) into at least two parts (7, 8) by removing parts of the front electrode (4) along at least one edge thereof;
k) optionally passivating at least one shunt (12) by removing parts of the front electrode at the area of the shunt (12);
l) optionally removing at least part of part (7) of the front electrode (4) in order to eliminate an electrical contact between part (7) of the front electrode and the back electrode and/or the electrically conductive carrier;
m) optionally removing particles and superficial parts of the buffer layer from the surfaces of the solar cell;
n) optionally applying at least one isolating structure (6) by applying at least one electrical isolator on top of the front electrode (4) on to at least part (7) which is electrically not isolated from the electrically conductive carrier (1) and the back electrode (2);
o) optionally applying at least one additional structure (6') by applying at least one electrical isolator on top of the back electrode (2) and/or the electrically conductive carrier (1);
p) optionally applying at least one additional structure (14) by applying at least one electrical isolator at least on top of the part 13 of the front electrode (4);
q) optionally applying at least one additional structure (14') by applying at least one electrical isolator at least on top of the part (16) of the front electrode (4);
r) providing at least one electrically non-conductive sheet of high optical transmission and mounting a first solar cell (10) with its front electrode thereon;
s) applying a conductive adhesive (9) on part of the back electrode (2) and/or electrically conductive carrier (1) which will be brought into electrical contact with that part (8') of the front electrode of a second solar cell (10') which is electrically isolated from the electrically conductive carrier (1') and the back electrode (2') of the front electrode (4') of a second solar cell (10') when assembled;
t) providing a second solar cell (10') and connecting the back electrode (2) and/or electrically conductive carrier (1) of the first solar cell (10) via the conductive adhesive (9) with part (8') of the front electrode (4') of the second solar cell (10') and
u) optionally repeating steps i) to u) until the desired number n of solar cells is connected in series
v) optionally curing the series of electrically connected solar cells;
w) providing an electrical contact to the electrically conductive carrier (1) of the last solar cell in the connected series and providing an electrical contact to the electrically conductive carrier of the first solar cell in the connected series so that n-1 solar cells are active; and
x) optionally conducting an efficiency test and selecting connected series that pass the test.
